# EUROPEAN PATENT APPLICATION

(11) **EP 3 495 828 A1**
(43) Date of publication of application: **12.06.2019**
(21) Application number: 17836789.2
(22) Date of filing: 24.07.2017
(51) Int. Cl.: G01R 1/073, G01R 31/26, H01L 21/66

(54) **PROBE CARD AND INSPECTION METHOD**

(30) Priority: 02.08.2016 JP 2016151786
(71) Applicant: Kabushiki Kaisha Nihon Micronics, Tokyo 180-8505 (JP)
(72) Inventor: KIKUTA Makoto, Musashino-shi Tokyo 180-8508 (JP); ANDO Hidenori, Musashino-shi Tokyo 180-8508 (JP)
(74) Representative: Guérin, Jean-Philippe
(86) International application number: PCT/JP2017/026606
(87) International publication number: WO 2018/025683

(57) **Abstract**

A probe card (100) according to the present invention inspects a workpiece (50) including a plurality of pads (51). The probe card (100) includes: a secondary battery (10) of a planar shape including a planar electrode (22) of a planar shape and disposed such that the planar electrode (22) faces the workpiece (50); and an electrical connection body (30) disposed between the workpiece (50) and the secondary battery (10). The secondary battery (10) includes a structure that a wiring can be drawn from an optional portion of the planar electrode (22). The electrical connection body (30) includes a plurality of contacts (31) protruding toward the facing pads (51), and electrically connects a plurality of pads (51) and the planar electrode (22) with a plurality of contacts (31) interposed therebetween.

## Description

### Technical Field

The present invention relates to a technique of performing electrical inspection by using a battery.

### Background Art

Patent Literature 1 discloses a probe card provided with a connection body between a probe substrate and a circuit board. Relay switches and capacitors are mounted on the probe card of Patent Literature 1. According to Patent Literature 1, the relay switches are appropriately disposed to suppress a variation of wiring lengths from a device to bypass capacitors.

### Citation List

### Patent Literature

PTL 1: Japanese Unexamined Patent Application Publication No. 2014-25761

### Summary of Invention

### Technical Problem

According to electrical inspection of such a semiconductor device, a difference between distances from a power source to contact points influences response performance and measurement precision. During electrical inspection, even a good circuit is decided as NG due to speed delay occurring from a voltage application instruction to a response.

For the delay of this response speed, there are a method for performing isometric patterning by a wiring design, and a method for canceling the delay of the response speed due to wiring distances by using capacitors. Furthermore, there is also a method for setting an effective area in which the speed delay does not matter, and performing offset inspection of limiting a collective measurement area from the effective area.

However, it is difficult to perform isometric patterning in a limited area. Furthermore, when isometric patterning is performed, it is necessary to design the wiring lengths according to the longest wiring length. Furthermore, according to the method for canceling the distance, when measurement channels increase, the number of circuit elements such as capacitors increases. Therefore, mounting the circuit elements becomes difficult, and mounting cost rises. The offset inspection requires a cycle time compared to collective measurement. Hence, the offset inspection is less productive than the collective measurement.

The present invention has been made in light of the above problem, and an object of the present invention is to provide a technique which can suppress a variation of a response speed of electrical inspection.

### Solution to Problem

A probe card according to one embodiment of the present embodiment is a probe card for inspecting a workpiece including a plurality of pads, and includes: a secondary battery of a planar shape including a planar electrode of a planar shape and disposed such that the planar electrode faces the workpiece; and an electrical connection body disposed between the workpiece and the secondary battery, and the electrical connection body includes a plurality of contacts protruding toward the facing pads, and electrically connects the plurality of pads and the planar electrode with the plurality of contacts interposed therebetween.

In the above probe card, a wiring length from the planar electrode to the facing contacts is preferably equal.

In the above probe card, the electrical connection body may include a Pogo pin configured to come into contact with the planar electrode.

In the above probe card, the electrical connection body may be connected to the planar electrode with a conductive adhesive interposed therebetween.

A secondary battery according to one embodiment of the present embodiment is a secondary battery of a planar shape for supplying power to an inspection apparatus for inspecting a workpiece including a plurality of pads, and includes: a battery element of a planar shape; and a planar electrode of a planar shape disposed to face above the battery element, and the planar electrode can extract a current from an optional position of the battery element.

An inspection method according to one embodiment of the present embodiment is an inspection method for inspecting a workpiece including a plurality of pads on a surface, and includes: disposing a probe card facing the workpiece; and placing a plurality of contacts provided to the probe card in contact with the pads, and the probe card includes a secondary battery of a planar shape including a planar electrode of a planar shape and disposed such that the planar electrode faces the workpiece, and an electrical connection body disposed between the workpiece and the secondary battery, and the electrical connection body includes a plurality of contacts protruding toward the facing pads, and electrically connects the plurality of pads and the planar electrode with the plurality of contacts interposed therebetween.

According to the above inspection method, a current may flow in a direction vertical to a planar direction of the planar electrode between the pads and the planar electrode in a state where the contacts are in contact with the pads.

According to the above inspection method, the electrical connection body may include a Pogo pin configured to come into contact with the planar electrode.

According to the above inspection method, the electrical connection body may be connected to the planar electrode with a conductive adhesive interposed therebetween.

### Advantageous Effects of Invention

According to the present invention, it is possible to provide a technique which can suppress a variation of a response speed of electrical inspection.

### Brief Description of Drawings

Fig. 1 is a perspective view illustrating a configuration of a probe card;
Fig. 2 is a cross-sectional view for explaining inspection by using the probe card;
Fig. 3 is a cross-sectional view illustrating a state where contacts of the probe card and pads are in contact;
Fig. 4 is a view illustrating a test configuration for measuring delay of a current supplied from a battery;
Fig. 5 is a graph illustrating a test result of the configuration in Fig. 4;
Fig. 6 is a cross-sectional view illustrating a configuration where circuit elements are mounted on an electrical connection body;
Fig. 7 is a cross-sectional view illustrating a configuration 1 for connecting the electrical connection body and the battery;
Fig. 8 is a cross-sectional view illustrating a configuration example 2 for connecting the electrical connection body and the battery; and
Fig. 9 is a cross-sectional view illustrating a configuration of a secondary battery used for the probe card.

### Description of Embodiments

One example of an embodiment of the present invention will be described below with reference to the drawings. The following description will describe the preferable embodiment of the present invention, and a technical scope of the present invention is not limited to the following embodiment.

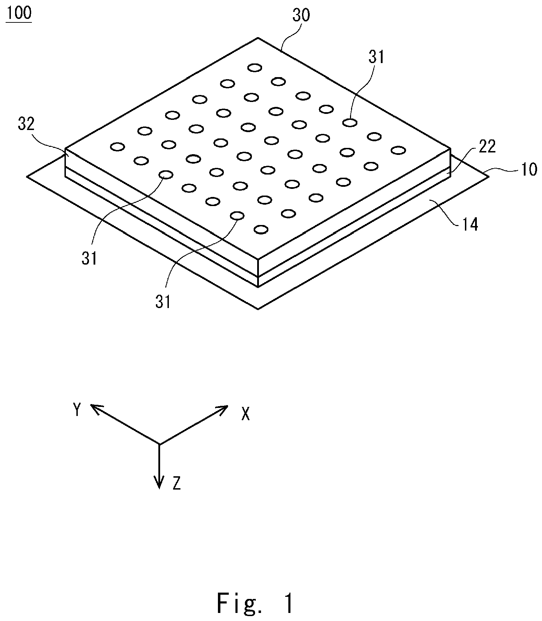

A configuration of a probe card according to the present embodiment will be described below with reference to Fig. 1. Fig. 1 is a perspective view illustrating a configuration of the probe card according to the present embodiment. In addition, for clarification of description, Fig. 1 illustrates an XYZ three-dimensional orthogonal coordinate system. A +Z direction is a touchdown direction, and is a vertically lower side during inspection. Furthermore, an XY plane is a planar direction perpendicular to the touchdown direction. Furthermore, an X direction and a Y direction are directions along end sides of a battery 10 of a rectangular shape.

A probe card 100 includes the battery 10 and an electrical connection body 30. The battery 10 is disposed on a +Z side of the electrical connection body 30. The battery 10 is, for example, a battery of a sheet shape, and disposed in parallel to the XY plane. The battery 10 includes a first electrode 14 and a second electrode 22. The battery 10 adopts, for example, a structure from which a wiring can be drawn from an optional portion of the second electrode 22. In addition, the battery 10 includes a charging layer between the first electrode 14 and the second electrode 22, yet is not illustrated in Fig. 1. In this regard, a detailed cross-sectional configuration of the battery 10 will be described below.

The first electrode 14 is formed by, for example, a metal sheet or a metal substrate. The first electrode 14 is a negative electrode. The first electrode 14 also becomes a base material for forming a laminated structure described below in some cases. The second electrode 22 is a positive electrode formed on a surface of the battery 10.

In a state before the electrical connection body 30 is disposed, the first electrode 14 is exposed from one surface of the battery 10, and the second electrode 22 is exposed from the other surface. The second electrode 22 is a planar electrode formed in a region except an edge of the first electrode 14. The first electrode 14 and the second electrode 22 are substantially parallel to the XY plane. In addition, the probe card according to the present embodiment will be described assuming that the first electrode 14 is the negative electrode and the second electrode 22 is the positive electrode. However, the first electrode 14 may be the positive electrode and the second electrode 22 may be the negative electrode.

The electrical connection body 30 of the flat plate shape is disposed facing the battery 10. The electrical connection body 30 includes a base portion 32 and contacts 31. The base portion 32 is a flat substrate along the XY plane. A plurality of contacts 31 are provided on a surface on a -Z side of the base portion 32. In this regard, a plurality of contacts 31 are arranged in an array pattern.

Each contact 31 protrudes from the base portion 32 to a -Z direction so as to come into contact with a facing workpiece. A distal end of each contact 31 is placed in contact with the facing workpiece by touchdown. In addition, the contacts 31 may employ any configuration as long as the contacts 31 protrude in the -Z direction. For example, cantilever-type probes may be the contacts 31. Alternatively, the contacts 31 may be Pogo pins which are biased by springs. The contacts 31 are preferably configured to be biased by pads by overdrive. That is, the contacts 31 preferably adopt a structure which produces an elastic force.

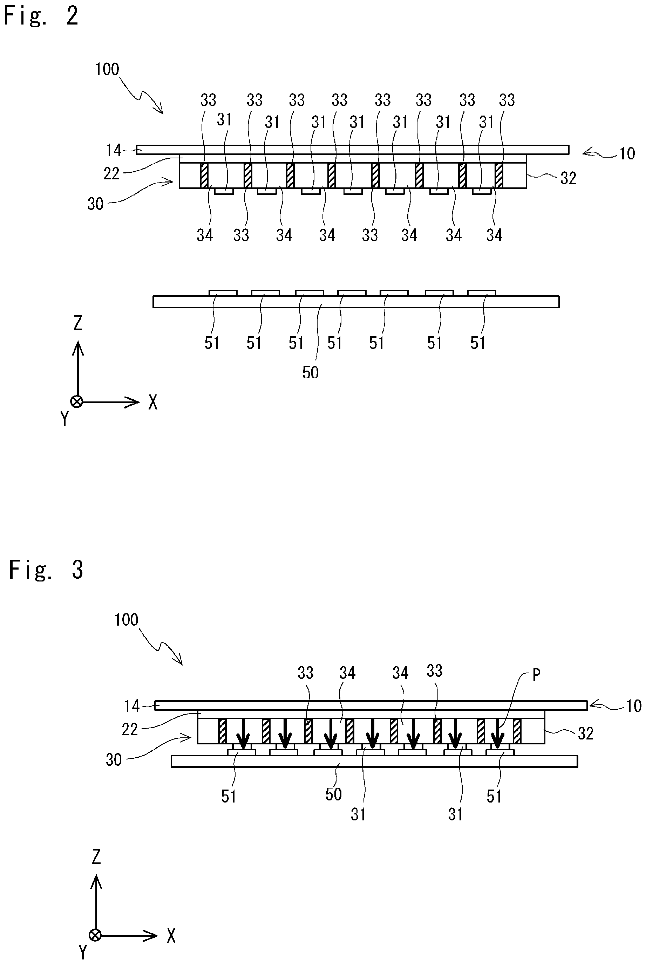

Furthermore, the configuration of the electrical connection body 30 will be described in detail with reference to Figs. 2 and 3. Fig. 2 is a cross-sectional view illustrating configurations of a workpiece 50 and the probe card 100. Fig. 3 is a cross-sectional view illustrating a state where the contacts 31 of the probe card 100 and pads 51 are in contact. The electrical connection body 30 is disposed between the workpiece 50 and the battery 10. That is, the battery 10 is disposed facing the workpiece 50 with the electrical connection body 30 interposed therebetween. The electrical connection body 30 may be detachably disposed on the battery 10.

The electrical connection body 30 is attached to the battery 10 to face the second electrode 22 of the battery 10. That is, an upper surface of the electrical connection body 30 faces a lower surface of the battery 10, and a lower surface (-Z direction) of the electrical connection body 30 faces an upper surface of the workpiece 50. The workpiece 50 is a semiconductor device such as a semiconductor wafer, a CCD device and a CMOS device. A plurality of pads 51 which input and output signals are provided on the upper surface (+Z direction) of the workpiece 50.

The base portion 32 includes a plurality of conduction portions 34 and a plurality of insulation portions 33. The conduction portions 34 are formed by a conductive material such as a metal. The conduction portions 34 extend in a Z direction to electrically connect the contacts 31 to the second electrode 22. The insulation portions 33 are formed by an insulation material such as a resin. The insulation portions 33 are disposed between the conduction portions 34 to insulate the neighboring conduction portions 34. The insulation portions 33 and the conduction portions 34 are alternately disposed in the X direction.

The insulation portions 33 are disposed between the two neighboring conduction portions 34 in the X direction and the Y direction. Thus, the neighboring conduction portions 34 are electrically insulated by the insulation portions 33. Furthermore, the contacts 31 are disposed right below the conduction portions 34. That is, the contacts 31 are electrically connected with the conduction portions 34 right above the contacts 31. By so doing, the neighboring contacts 31 are electrically insulated. Consequently, it is possible to independently supply inspection signals to the contacts 31.

Each of a plurality of contacts 31 protrudes from a lower surface of the base portion 32 to the -Z direction. When the contacts 31 are placed in contact with the pads 51 by touchdown, a positional relationship between the probe card 100 and the workpiece 50 is as illustrated in Fig. 3. That is, the second electrode 22 and the contacts 31 are electrically conducted via the conduction portions 34 by touchdown. The first electrode 14 of the battery 10 and a ground of the workpiece 50 are common. Hence, a current (inspection signal) from the battery 10 is supplied to the facing pad 51 via each contact 31.

The contacts 31 and the conduction portions 34 form current paths P (arrows in Fig. 3) from the second electrode 22 to the pads 51 in the respective pads. Consequently, it is possible to electrically independently supply the current to each pad 51.

A wiring pattern along the XY plane is not provided on the second electrode 22, so that the current does not flow along the XY plane. That is, the current paths P cause the current from the battery 10 to flow mainly in the Z direction. In other words, the wiring lengths from the second electrode 22 to the pads 51 are determined according to the thickness in the Z direction of the electrical connection body 30.

In this regard, the thickness in the Z direction of the electrical connection body 30 is uniform, so that it is possible to make the wiring lengths with respect to all of the pads 51 nearly isometric. That is, Fig. 3 illustrates that all wiring lengths from the second electrode 22 to the pads 51 are substantially isometric to the wiring lengths of the current paths P. The wiring lengths are substantially isometric, so that it is possible to cause the current from the battery 10 to flow to the pads 51 without speed delay. That is, the probe card according to the present embodiment can prevent a variation of a response speed of an inspection signal and consequently appropriately electrically inspect the workpiece 50.

The battery 10 is a secondary battery of a planar shape which supplies power to the inspection device which inspects a workpiece including a plurality of pads. The battery 10 includes the second electrode 22 which does not cause response delay of a current obtaining time even when the current is extracted from an optional position. The wiring length from the second electrode 22 to each contact 31 is equal, and the current flows to each contact 31 from the second electrode 22 in the -Z direction.

Furthermore, the neighboring contacts 31 are insulated by the insulation portions 33, so that the current from the battery 10 independently flows to each contact 31. For example, the current flowing from the battery 10 to each pad 51 is used as an inspection signal to electrically inspect the workpiece 50.

An output voltage of the battery 10 is fixed in the entire second electrode 22. Consequently, the same output voltage is supplied to a plurality of pads 51 from the battery 10. When loads in the workpiece 50 differ depending on the pads 51, a current corresponding to the load of each pad 51 is supplied to each pad 51 from the battery 10. Consequently, it is possible to perform appropriate electrical connection.

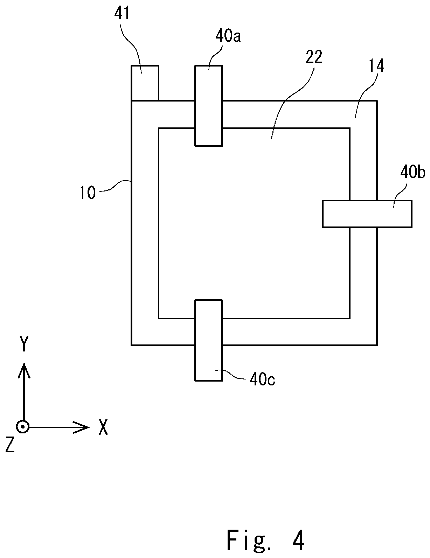

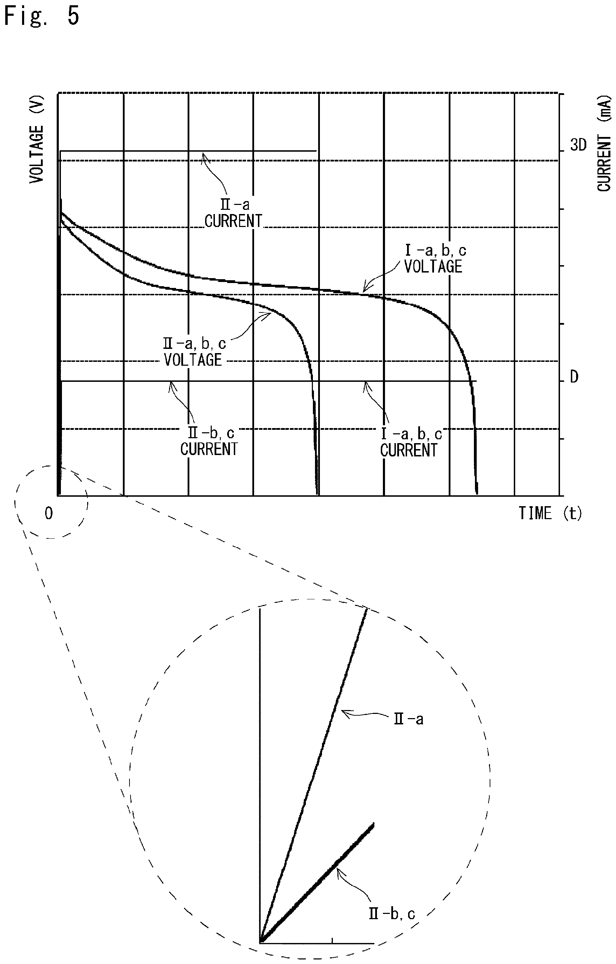

That a current can be appropriately supplied from the battery 10 to each pad 51 will be described with reference to Figs. 4 and 5. Fig. 4 is a plan view illustrating a configuration for performing a discharge test of the battery 10. Fig. 5 is a graph illustrating a test result of the configuration illustrated in Fig. 4.

As illustrated in Fig. 4, three positive electrode terminals 40a to 40c are attached to the second electrode 22 of the battery 10. The three positive electrode terminals 40a to 40c are attached to different positions of the second electrode 22 on the XY plane. More specifically, the positive electrode terminal 40a is attached to an end portion on a +Y side of the second electrode 22, the positive electrode terminal 40b is attached to an end portion on a +X side, and the positive electrode terminal 40c is attached to an end portion on -Y side. Furthermore, one negative electrode terminal 41 is attached to the first electrode 14 which is the negative electrode.

Fig. 5 illustrates a measurement result obtained by connecting a charging/discharging power source to each of the positive electrode terminals 40a to 40c in Fig. 4, and causing the charging/discharging power source to simultaneously discharge. Fig. 5 illustrates temporal changes of a discharge voltage and a discharge current when the following two discharge tests were conducted. Fig. 5 illustrates measurement results of the positive electrode terminals 40a to 40c as a, b and c.

In a test I, the same discharge current is extracted from the three positive electrode terminals 40a to 40c. More specifically, discharging is performed to extract same current values D from the positive electrode terminals 40a to 40c. In a test II, the discharge current extracted from the positive electrode terminal 40a is made higher than the discharge currents from the positive electrode terminals 40b and 40c.

More specifically, discharging is performed to respectively extract a current value 3D from the positive electrode terminal 40a and the current values D from the positive electrode terminals 40b and 40c. Furthermore, in each of the test I and the test II, the positive electrode terminals 40a to 40c simultaneously start discharging. That is, the currents are simultaneously extracted from the positive electrode terminals 40a to 40c.

In the test I, the discharge currents from the three positive electrode terminals 40a to 40c are equal. The currents can be evenly extracted from all of the positive electrode terminals 40a to 40c. Furthermore, the discharge currents are substantially fixed until discharging ends. Thus, the current values D are stably extracted from the positive electrode terminals 40a to 40c. Furthermore, the discharge voltages of the positive electrode terminals 40a to 40c equally change.

In the test II, the discharge currents from the positive electrode terminals 40b and 40c are equal. The discharge current from the positive electrode terminal 40a is substantially fixed at the current value 3D. Furthermore, the discharge currents from the positive electrode terminals 40b and 40c are substantially fixed at the current value D. The discharge current from the positive electrode terminal 40a is three times as the discharge current from the positive electrode terminals 40b or 40c. The discharge voltages of the positive electrode terminals 40a to 40c equally change. Thus, the current value 3D is stably extracted from the positive electrode terminal 40a, and the current values D are stably extracted from the positive electrode terminals 40b and 40c. In the test II, the current value discharged from the battery 10 is higher than that of the test I. Hence, a voltage drop resulting from discharging in the test II is faster than that in the test I.

Furthermore, Fig. 5 illustrates an enlarged discharge current immediately after start of discharging in the test II. It is possible to confirm that, even when the discharge currents differ, a current rise is not delayed.

In both of the test I and the test II, a desired current can be stably extracted. That is, it is possible to confirm that there is no response delay depending on an extraction position of the second electrode 22. In other words, there is no response delay even when the current is extracted from an optional position of the second electrode 22.

Furthermore, even when a different current is extracted from a different position as in the test II, response delay does not occur. Consequently, it is possible to appropriately supply the current from an optional position of the second electrode 22. Consequently, even when the probe card 100 illustrated in Figs. 1 to 3 is used, it is possible to suppress a variation of a response speed of a signal for each pad 51.

Furthermore, when the inspection voltage supplied from the battery 10 needs to be changed according to each pad 51, a resistance only needs to be connected in series in each current path. By so doing, a resistance voltage division allows an appropriate voltage to be supplied to each pad 51. By, for example, adjusting resistances of the conduction portions 34 and the contacts 31, it is possible to change the inspection voltage to be supplied to the workpiece 50 per pad 51. Furthermore, resistance elements may be disposed in the current paths. More specifically, the resistance elements only need to be formed near the contacts 31 on the lower surface of the electrical connection body 30.

Furthermore, relay switches can be also provided to the electrical connection body 30. By so doing, it is possible to control a timing to supply the inspection signal to each contact 31. That is, by switching on and off of the relay switches, it is possible to control a timing of a current flowing via the contacts 31. For example, the relay switches only need to be formed near the contacts 31 on the lower surface of the electrical connection body 30.

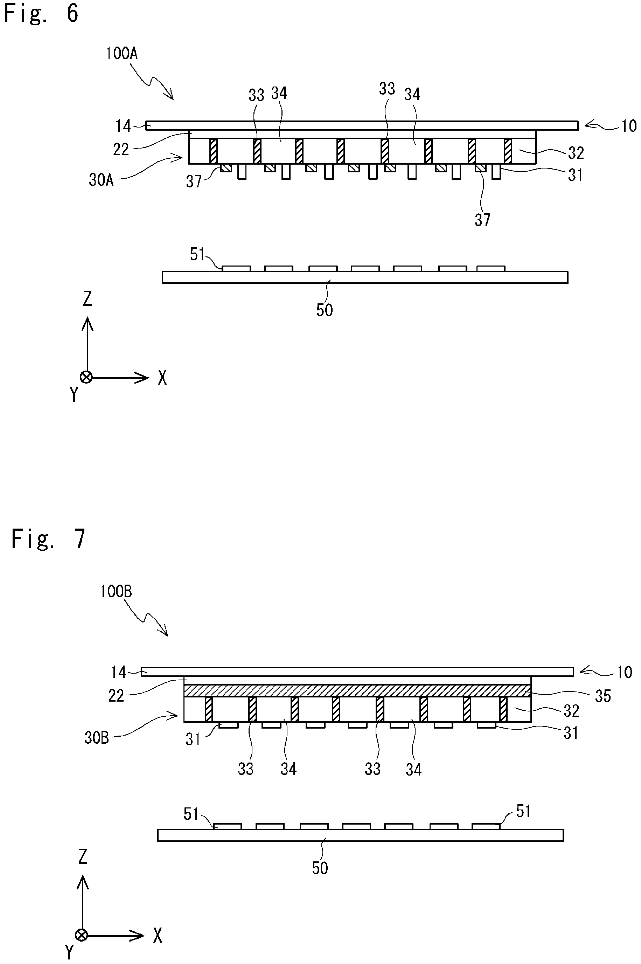

Fig. 6 illustrates a configuration of a probe card 100A including circuit elements 37 such as resistance elements or relay switches. The circuit elements 37 are mounted on a lower surface of an electrical connection body 30A. The contacts 31 protrude toward the -Z side compared to the circuit elements 37. The circuit elements 37 are not limited to the above relay switches or resistance elements, and may be capacitors. In addition, circuit elements may be mounted on a circuit board different from that of the electrical connection body 30A. That is, the circuit board on which the circuit elements 37 are mounted may be further added to the probe card 100. Furthermore, wirings for controlling the circuit elements 37 may be provided to at least one of the electrical connection body 30 and the circuit board.

In addition, when the battery 10 has a larger size than that of the workpiece 50, the entire workpiece 50 can be collectively inspected. That is, the second electrode 22 of the battery 10 faces all pads of the workpiece 50. Consequently, it is possible to simultaneously supply inspection signals (currents) from the battery 10 to all of the pads 51. In this case, the electrical connection body 30 is provided with the contacts 31 associated with all of the pads 51. When, for example, the size of the battery 10 on the XY plane is a square shape of 350 mm × 350 mm, it is possible to collectively inspect semiconductor wafers with a diameters of 300 mm. Consequently, it is possible to perform highly productive inspection.

Furthermore, when the battery 10 has a smaller size than that of the workpiece 50, the workpiece 50 only needs to be electrically inspected over a plurality of times. That is, by changing relative position between the probe card 100 and the workpiece 50 on the XY plane, and repeating touchdown, it is possible to inspect the entire workpiece 50.

Next, a configuration for connecting the battery 10 and the electrical connection body 30 will be described. Fig. 7 is a cross-sectional view illustrating a configuration 1 for connecting the battery 10 and an electrical connection body 30B. Fig. 7 illustrates a probe card 100B in which the battery 10 and the electrical connection body 30B are connected with a conductive adhesive 35 interposed therebetween. The conductive adhesive 35 is a member of a sheet shape having the substantially same size as that of the electrical connection body 30B, and adheres the battery 10 and the electrical connection body 30B. The second electrode 22 and the conduction portions 34 are electrically connected with each other via the conductive adhesive member 35. By so doing, the current outputted from the battery 10 is supplied to the pads 51 via the conductive adhesive member 35. Consequently, it is possible to perform appropriate electrical inspection.

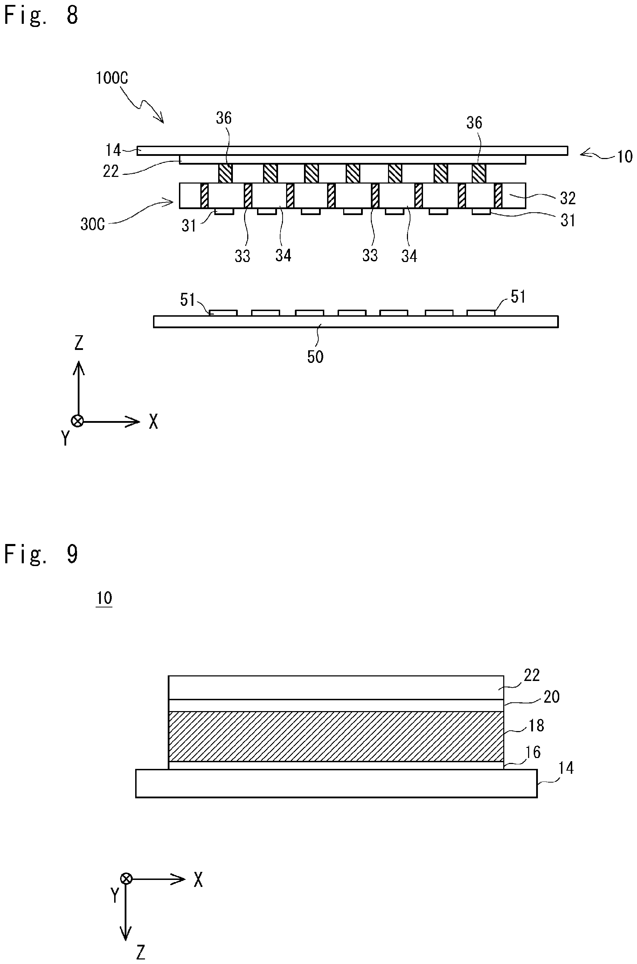

Fig. 8 is a cross-sectional view illustrating a configuration example 2 for connecting the battery 10 and an electrical connection body 30C. Fig. 8 illustrates a probe card 100C in which the battery 10 and the electrical connection body 30 are connected with Pogo pins 36 interposed therebetween. The Pogo pins 36 protrude from the upper surface of the base portion 32 to the +Z direction. Hence, the Pogo pins 36 contact the second electrode 22. A plurality of Pogo pins 36 are provided meeting a plurality of contacts 31.

The second electrode 22 and the conduction portions 34 conduct via the Pogo pins 36. By so doing, the current outputted from the battery 10 is supplied to the pads 51 via the Pogo pins 36. Consequently, it is possible to perform appropriate electrical inspection. Furthermore, by using the Pogo pins 36, it is possible to easily detach and attach the battery 10 and the electrical connection body 30. Consequently, when the capacity and performance of the battery 10 lower, it is possible to easily exchange the battery 10.

Next, a laminated structure of the battery 10 will be described with reference to Fig. 9. Fig. 1 is a cross-sectional view schematically illustrating the configuration of the battery 10. The battery 10 adopts a laminated structure that the first electrode 14, an n-type oxide semiconductor layer 16, a charging layer 18, a p-type oxide semiconductor layer 20, and the second electrode 22 are laminated in this order (a state where the first electrode 14 and the second electrode 22 are removed from the battery 10 will be referred to as a "battery element" below). The battery 10 adopts this laminated structure, and, consequently, the second electrode 22 adopts a structure that a wiring can be drawn from an optional portion of a battery element.

The first electrode 14 is formed by a conductive sheet or a conductive substrate, and functions as a base material for forming the laminated structure. For example, a metal foil sheet can be used as the first electrode 14. In this case, an SUS (Steel Use Stainless) sheet is used as the first electrode 14. Alternatively, the metal foil sheet such as copper or aluminum may be used as the first electrode 14.

In addition, it is also possible to prepare the base material made of an insulation material, and form the first electrode 14 on the base material. When the first electrode 14 is formed on the base material, a metal material such as chrome (Cr) or titanium (Ti) can be used as the material of the first electrode 14. An alloy film containing aluminum (Al) or silver (Ag) may be used as the material of the first electrode 14. When the first electrode 14 is formed on the base material, the first electrode 14 can be formed in the same way as the second electrode 22 described below.

The n-type oxide semiconductor layer 16 is formed on the first electrode 14. A titanium dioxide (TiO2), a tin oxide (SnO2) or a zinc oxide (ZnO) can be used as the material of the n-type oxide semiconductor layer 16. A titanium oxide can be used as the n-type oxide semiconductor layer 16. The thickness of the n-type oxide semiconductor layer 16 is preferably 30 nm to 120 nm. For example, the titanium oxide with a thickness of 60 to 120 nm can be used as the n-type oxide semiconductor layer 16. For example, an n-type oxide semiconductor can be formed as a film on the first electrode 14 by spattering or evaporation deposition.

The charging layer 18 is formed on the n-type oxide semiconductor layer 16. The charging layer 18 is formed by a mixture obtained by mixing the insulation material and the n-type oxide semiconductor material. For example, the n-type oxide semiconductor of fine particles can be used as the n-type oxide semiconductor material of the charging layer 18. The n-type oxide semiconductor causes a change in a photoexcitation structure when irradiated with an ultraviolet ray, and becomes a layer having a charging function. The n-type oxide semiconductor contains a mixture obtained by mixing the n-type oxide semiconductor material and the insulation material. A silicone resin can be used as the insulation material. For example, it is preferable to use a silicon compound (silicone) having a main skeleton formed by siloxane binding of a silicon oxide.

For example, the n-type oxide semiconductor is formed by a silicon oxide and a titanium dioxide. The n-type oxide semiconductor material which can be used for the charging layer 18 is optionally a titanium dioxide (TiO2), a tin oxide (SnO2) or a zinc oxide (ZnO). A material obtained by combining two or all of the titanium dioxide, the tin oxide or the zinc oxide can be also used. The charging layer 18 contains a mixture obtained by mixing the insulation material and the n-type oxide semiconductor material.

A manufacturing process of the charging layer 18 will be described. First, a coating solution obtained by mixing a solvent in a mixture of a precursor of the titanium dioxide, the tin oxide or the zinc oxide and a silicone oil. A coating solution obtained by mixing fatty acid titanium and the silicone oil in a solvent is prepared. Furthermore, the coating solution is coated on the n-type oxide semiconductor layer 16 by a spin coating method and a slit coating method. By drying and calcining the coating film, it is possible to form the charging layer 18 on the n-type oxide semiconductor layer 16. In addition, for example, titanium stearate which is the precursor of the titanium oxide can be used as one example of the precursor. The titanium oxide, the tin oxide and the zinc oxide are made by decomposing aliphatic salt which is a precursor of a metal oxide. The dried and calcined charging layer 18 may be irradiated by an ultraviolet ray and be UV-cured.

In addition, fine particles of an oxide semiconductor can be also used for the titanium oxide, the tin oxide and the zinc oxide without using the precursor. By mixing nano particles of the titanium oxide or the zinc oxide with the silicone oil, a mixed solution is generated. Furthermore, by mixing a solvent in the mixed solution, a coating solution is generated. The coating solution is coated on the n-type oxide semiconductor layer 16 by the spin coating method or the slit coating method. By drying, calcining and performing UV irradiation on the coating film, it is possible to form the charging layer 18.

The p-type oxide semiconductor layer 20 is formed on the charging layer 18. The p-type oxide semiconductor layer 20 is provided to prevent injection of electrons from the second electrode 22 at the upper portion to the charging layer 18. A nickel oxide (NiO) and a copper aluminum oxide (CuAlO2) can be used as the material of the p-type oxide semiconductor layer 20. For example, the p-type oxide semiconductor layer 20 is an oxide nickel film with a thickness of 400 nm. The p-type oxide semiconductor layer 20 is formed as a film on the charging layer 18 by a film forming method such as evaporation deposition or spattering.

The second electrode 22 is formed on the p-type oxide semiconductor layer 20. The second electrode 22 only needs to be formed by a conductive film. Furthermore, a metal material such as chrome (Cr) or copper (Cu) can be used as a material of the second electrode 22. The other metal materials include a silver (Ag) alloy containing aluminum (Al). A forming method of the second electrode 22 includes vapor deposition such as spattering, ion plating, electron beam deposition, vacuum deposition or chemical deposition. Alternatively, a metal electrode can be formed by an electroplating method or an electroless plating method. Generally, copper, a copper alloy, nickel, aluminum, silver, gold, zinc or tin can be used for a metal used for plating. For example, the second electrode 22 is an Al film with a thickness of 300 nm.

The charging layer 18 is provided right below the second electrode 22. Consequently, even when a current is extracted from an optional position of the second electrode 22, it is possible to prevent response delay. The battery 10 is an all solid state secondary battery which does not use an electrolyte solution, and consequently can be used without being sealed. That is, the battery 10 can be charged and discharged in a state where the second electrode 22 is exposed. Consequently, the battery 10 is optimal for electrical inspection according to the present embodiment. Furthermore, the electrical connection body 30 and the battery 10 are detachable, so that it is possible to easily exchange the battery 10. The battery 10 may be connected to an external power source and charged during inspection or after inspection.

The battery 10 has a large electric power storage capacity compared to a capacitor, and consequently can inspect devices which need a great amount of power. Furthermore, the battery 10 is suitable to measurement which uses a radio frequency signal, too.

Furthermore, the battery used for the probe card 100 according to the present embodiment is optimally the battery 10 adopting the above laminated structure, yet may be other batteries. That is, batteries with electrodes formed on surfaces are applicable to the probe card 100 according to the present embodiment. For example, a lithium ion battery may be the battery 10.

An inspection method according to the present embodiment includes a step of disposing the probe card 100 and the workpiece 50 facing each other, and a step of placing the contacts 31 provided to the probe card 100 and the pads 51 in contact.

One example of the embodiment of the present invention has been described above, yet includes appropriate modifications without undermining the object and the advantage of the present invention and, furthermore, is not limited by the above embodiment.

This application claims priority to Japanese Patent Application No. 2016-151786 filed on August 2, 2016, the entire contents of which are incorporated by reference herein.

### Reference Signs List

- 100: PROBE CARD
- 10: BATTERY
- 14: FIRST ELECTRODE
- 16: n-TYPE OXIDE SEMICONDUCTOR LAYER
- 18: CHARGING LAYER
- 20: p-TYPE OXIDE SEMICONDUCTOR LAYER
- 22: SECOND ELECTRODE
- 30: ELECTRICAL CONNECTION BODY
- 31: CONTACT
- 32: BASE PORTION
- 33: INSULATION PORTION
- 34: CONDUCTION PORTION
- 35: CONDUCTIVE ADHESIVE MEMBER
- 36: POGO PIN
- 37: CIRCUIT ELEMENT
- 40: POSITIVE ELECTRODE TERMINAL
- 41: NEGATIVE ELECTRODE TERMINAL
- 50: WORKPIECE
- 51: PAD

## Claims

1. A probe card for inspecting a workpiece including a plurality of pads, the probe card comprising:
a secondary battery of a planar shape including a planar electrode of a planar shape and disposed such that the planar electrode faces the workpiece; and
an electrical connection body disposed between the workpiece and the secondary battery, wherein
the secondary battery includes a structure by which a wiring can be drawn from an optional position of the planar electrode, and
the electrical connection body includes a plurality of contacts protruding toward the facing pads, and electrically connects the plurality of pads and the planar electrode with the plurality of contacts interposed therebetween.

2. The probe card according to Claim 1, wherein wiring lengths from the planar electrode to the respective facing contacts are equal to each other.

3. The probe card according to Claim 1 or 2, wherein the electrical connection body includes a Pogo pin configured to come into contact with the planar electrode.

4. The probe card according to Claim 1 or 2, wherein the electrical connection body is connected to the planar electrode with a conductive adhesive interposed therebetween.

5. A secondary battery of a planar shape for supplying power to an inspection apparatus for inspecting a workpiece including a plurality of pads, the secondary battery comprising:
a battery element of a planar shape; and
planar electrodes of a planar shape disposed to face each other above the battery element,
wherein the planar electrodes can extract a current from an optional position of the battery element.

6. An inspection method for inspecting a workpiece including a plurality of pads on a surface, the inspection method comprising:
disposing a probe card facing the workpiece; and
placing a plurality of contacts provided to the probe card in contact with the pads, wherein
the probe card includes
a secondary battery of a planar shape including a planar electrode of a planar shape and disposed such that the planar electrode faces the workpiece, and
an electrical connection body disposed between the workpiece and the secondary battery, and
the electrical connection body includes a plurality of contacts protruding toward the facing pads, and electrically connects the plurality of pads and the planar electrode with the plurality of contacts interposed therebetween.

7. The inspection method according to Claim 6, wherein a current flows in a direction vertical to a planar direction of the planar electrode between the pads and the planar electrode in a state where the contacts are in contact with the pads.

8. The inspection method according to Claim 6 or 7, wherein the electrical connection body includes a Pogo pin configured to come into contact with the planar electrode.

9. The inspection method according to Claim 6 or 7, wherein the electrical connection body is connected to the planar electrode with a conductive adhesive interposed therebetween.
